# FASCICULE DE BREVET EUROPEEN

(11) **EP 3 459 120 B1**
(45) Date de publication et mention de la délivrance du brevet: **18.03.2020**
(21) Numéro de dépôt: 17722073.8
(22) Date de dépôt: 12.05.2017
(51) Int. Cl.: H01L 31/0445, H01L 31/0224, H01L 31/18

(54) **DISPOSITIF PHOTOVOLTAÏQUE EN COUCHES MINCES ET PROCÉDÉ DE FABRICATION ASSOCIÉ**
DÜNNSCHICHTFOTOVOLTAIKVORRICHTUNG UND ZUGEHÖRIGES VERFAHREN ZUR HERSTELLUNG
THIN-FILM PHOTOVOLTAIC DEVICE AND ASSOCIATED METHOD OF PRODUCTION

(30) Priorité: 20.05.2016 FR 1654559
(43) Date de publication de la demande: 27.03.2019
(73) Titulaire: Electricité de France, 75008 Paris (FR); Paris Sciences et Lettres - Quartier Latin, 75006 Paris (FR); Centre National de la Recherche Scientifique - CNRS, 75016 Paris (FR)
(72) Inventeur: PAIRE, Myriam, 75017 Paris (FR); DUCHATELET, Aurélien, 78640 Neauphle le Vieux (FR); GRAND, Pierre-Philippe, 83470 Saint-Maximin la Sainte Baume (FR); JUTTEAU, Sébastien, 91430 Igny (FR)
(74) Mandataire: Plasseraud IP
(86) Numéro de dépôt international: PCT/EP2017/061514
(87) Numéro de publication internationale: WO 2017/198577

(56) Documents cités:
- EP-A2- 2 416 376
- US-A1- 2009 205 710
- US-A1- 2016 005 899

## Description

### DOMAINE TECHNIQUE

L'invention se rapporte au domaine des dispositifs photovoltaïques en couches minces. L'invention trouve notamment application dans la fabrication de contacts électriques dans des dispositifs photovoltaïques en couches minces, tels que par exemple des dispositifs photovoltaïques équipés d'un concentrateur de lumière.

### ARRIÈRE-PLAN TECHNOLOGIQUE

Les cellules solaires sont des dispositifs photovoltaïques comprenant un matériau aux propriétés photovoltaïques appelé absorbeur convertissant l'énergie de la lumière incidente arrivant sur la cellule en courant électrique. Le courant ainsi généré est collecté par des contacts électriques répartis de part et d'autre de l'absorbeur.

Afin d'accroitre les performances des dispositifs photovoltaïques, il convient de fabriquer des contacts électriques de bonne qualité, placés à proximité de l'absorbeur tout en permettant à la lumière incidente d'atteindre l'absorbeur.

L'une des problématiques qui se pose dans la fabrication de contacts électriques dans un dispositif photovoltaïque est l'agencement de ces derniers par rapport à l'absorbeur. En effet, il est souhaitable de positionner les contacts électriques au plus près de l'absorbeur, sans toutefois masquer l'absorbeur. Plus les contacts électriques sont éloignés de l'absorbeur, plus les pertes résistives lors du passage du courant de l'absorbeur vers ces contacts électriques augmentent. Toutefois, le positionnement des contacts électriques au plus près de l'absorbeur se heurte à plusieurs difficultés.

Dans le contexte des cellules solaires cristallines, l'absorbeur est issu d'un wafer découpé en cellules, les cellules étant ensuite assemblées sur un panneau photovoltaïque. Les cellules solaires cristallines reposent sur des technologies de fabrication dont le coût augmente avec le nombre de cellules solaires utilisées pour un panneau de taille fixe.

Ce problème de positionnement de la cellule par rapport aux contacts électriques intervient tout particulièrement dans les dispositifs photovoltaïques « à concentration de lumière ».

Un dispositif photovoltaïque « à concentration de lumière » comprend en outre un système optique concentrant la lumière sur une surface réduite du substrat, sur l'absorbeur, l'absorbeur ne recouvrant qu'une fraction de la surface du panneau photovoltaïque. Dans ces dispositifs, une quantité plus petite d'absorbeur est nécessaire puisque la lumière incidente est focalisée sur une petite surface du panneau solaire. Toutefois, le positionnement d'un absorbeur possédant des dimensions réduites dans un dispositif photovoltaïque à concentration de lumière requiert une précision encore plus grande.

Dans les systèmes à concentration de lumière, l'intensité lumineuse reçue par l'absorbeur est plus élevée que dans les dispositifs photovoltaïques dépourvus de concentrateurs de lumière. Par conséquent, les pertes résistives entre l'absorbeur et les contacts électriques sont encore plus grandes dans un dispositif photovoltaïque à concentration de lumière, et motivent donc la recherche de moyens de positionnement des contacts électriques au plus près de l'absorbeur.

Une solution permettant de contrôler plus précisément le placement des contacts électriques par rapport à l'absorbeur consiste à opter pour l'utilisation de cellules solaires en couches minces. Les dispositifs photovoltaïques en couches minces suscitent en outre un vif intérêt de par leurs coûts de fabrication plus faibles que ceux des cellules solaires cristallines, et l'utilisation de techniques de fabrication adaptées à des applications industrielles comme par exemple l'électro-dépôt, la co-évaporation, la pulvérisation cathodique, ou l'impression d'encres.

On entend par dispositif photovoltaïque en couches mince, un dispositif comprenant des matériaux sous forme de couche dont l'épaisseur peut typiquement varier de quelques couches atomiques à une dizaine de micromètres. La notion de dispositif en couches minces est connue de l'Homme de l'art, et en particulier dans le domaine photovoltaïque.

L'électro-dépôt et l'impression sont des techniques de dépôt sélectif qui permettent d'utiliser moins de matière pour fabriquer des couches minces.

On entend par dépôt sélectif un dépôt dans lequel l'emplacement du matériau déposé dépend de la nature chimique et/ou électrique du substrat sur lequel le dépôt est réalisé. Il suffit donc typiquement avec un dépôt sélectif, de prévoir un substrat dont les propriétés varient spatialement. Par exemple si un substrat a des zones hydrophiles et hydrophobes des liquides aqueux peuvent thermodynamiquement se localiser sur les zones hydrophiles.

Si le substrat a des zones conductrices électriques et isolantes, un électro-dépôt pourrait ne se faire que sur la zone conductrice. Ainsi dépôt sélectif s'entend par opposition aux dépôts à travers un masquage, ou à un dépôt plus une étape de structuration. Par exemple une impression dans laquelle la buse d'impression motorisée se déplace pour déposer des gouttes sur un substrat n'est pas nécessairement sélective. Par contre une impression dans laquelle un substrat est plongé dans un bain d'encre et dans laquelle l'encre ne se localise qu'à certains endroits grâce à un contraste hydrophile/hydrophobe, est considérée comme étant sélective.

L'électro-dépôt peut notamment être utilisé pour réaliser les différentes couches qui constituent un dispositif photovoltaïque à concentration de lumière, comme décrit dans le document WO 2011/151338. Toutefois, malgré les nombreux avantages en termes de contrôle et de précision de positionnement des contacts électriques offerts par l'électro-dépôt, les procédés de fabrication des dispositifs photovoltaïques en couches minces présentent d'autres contraintes rendant difficile l'obtention de contacts électriques de qualité au plus près de l'absorbeur.

La fabrication d'une cellule solaire en couches minces comprend généralement des étapes de recuit impliquant des températures supérieures à 500°C. Pour éviter d'endommager les contacts électriques dans ces conditions le contact électrique associé à la surface supérieure de l'absorbeur est généralement fabriqué à la fin du procédé de fabrication de la cellule. Dans cette configuration, le contact électrique sur la face avant du dispositif photovoltaïque en couches minces repose sur une partie supérieure de l'absorbeur, et peut donc en obscurcir une partie. Cet agencement du contact électrique sur la surface avant du dispositif photovoltaïque n'est donc pas satisfaisant.

Le document WO 2011/151338 propose un agencement sensiblement différent dans lequel le contact électrique est déposé sur une couche isolante structurée de sorte à laisser des ouvertures au-dessus de l'absorbeur pour y déposer une couche fenêtre électriquement conductrice et transparente. Le contact électrique est donc disposé au plus près de l'absorbeur sans le recouvrir, le courant pouvant transiter depuis l'absorbeur vers le contact électrique par la couche fenêtre. Toutefois, un tel agencement implique une étape de fabrication complexe et coûteuse pour la réalisation de la couche isolante structurée et le dépôt ultérieur du contact électrique sur la surface supérieure de cette couche isolante. En outre, le contact électrique opaque recouvre alors une grande partie du panneau solaire, le rendant opaque bien qu'une petite partie seulement du panneau soit effectivement utilisé en tant que convertisseur de lumière en électricité.

Il est par conséquent recherché un dispositif photovoltaïque dans lequel les contacts électriques ne recouvrent pas l'absorbeur et sont disposés au plus près de ce dernier, ainsi qu'un procédé de fabrication de ce dispositif qui soit simple et peu coûteux.

Le document EP 2 416 376 A2 décrit un dispositif photovoltaïque en couches minces comprenant un substrat, un premier contact électrique du dispositif photovoltaïque formé sur le substrat, un absorbeur agencé sur le premier contact électrique, une couche transparente conductrice agencée sur l'absorbeur, et un deuxième contact électrique du dispositif photovoltaïque.

Le document US 2016/005899 A1 décrit un dispositif photovoltaïque en couches minces comprenant un substrat, un premier contact électrique du dispositif photovoltaïque formé sur le substrat, un absorbeur agencé sur le premier contact électrique, un deuxième contact électrique du dispositif photovoltaïque formé sur le substrat, et une couche transparente conductrice agencée entre le deuxième contact électrique et l'absorbeur. Le deuxième contact électrique est espacé du premier contact électrique et la couche transparente conductrice est en contact avec l'absorbeur et le deuxième contact électrique. Un mode de réalisation décrit une structuration de manière interdigitée du premier contact électrique et de la couche transparente conductrice.

### EXPOSE DE L'INVENTION

Pour répondre aux problèmes exposés ci-avant, la présente invention propose un dispositif photovoltaïque en couches minces agencé sous forme de panneau photovoltaïque semi-transparent, comprenant :
- un substrat,
- au moins une première couche mince électriquement conductrice formant un premier contact électrique du dispositif photovoltaïque sur le substrat,
- un absorbeur agencé sur le premier contact électrique,
- au moins une deuxième couche mince électriquement conductrice formant un deuxième contact électrique du dispositif photovoltaïque sur le substrat,
- une couche transparente conductrice agencée sur l'absorbeur,
le deuxième contact électrique étant espacé du premier contact électrique et la couche transparente conductrice étant en contact avec l'absorbeur et le deuxième contact électrique, et dans lequel le deuxième contact électrique et le premier contact électrique sont structurés de manière interdigitée.

L'invention propose ainsi un dispositif photovoltaïque en couches minces dans lequel les deux contacts électriques sont disposés sur un substrat, du même côté de ce substrat que la couche d'absorbeur. Cet agencement diffère des contacts électriques de l'art antérieur qui reposent sur au moins un contact électrique agencé sur une surface supérieure du dispositif photovoltaïque et non sur le substrat, afin de maintenir un écart entre les deux contacts électriques et éviter un court-circuit. L'invention, en agençant les deux contacts sur une même surface du substrat, du même côté du substrat que l'absorbeur, tout en maintenant un écart entre les deux contacts électriques, simplifie l'agencement du dispositif et évite d'obscurcir la couche d'absorbeur.
Cette structuration des deux contacts électriques d'un dispositif photovoltaïque présente en outre l'avantage de permettre une fabrication simplifiée des deux contacts, pendant ou avant le dépôt de l'absorbeur, par exemple en utilisant des techniques de gravure. L'espace entre les deux contacts électriques peut donc être contrôlé avec une plus grande précision que dans des techniques impliquant un dépôt sur une surface supérieure de l'absorbeur. La couche transparente électriquement conductrice assure le passage du courant depuis l'absorbeur vers le deuxième contact électrique, en recouvrant l'espace séparant le premier contact électrique du deuxième contact électrique.

Selon l'invention, le deuxième contact électrique et le premier contact électrique sont structurés de manière interdigitée. Il est entendu par « interdigité » une structure dans laquelle le premier contact comprend des parties saillantes agencées en regard de portions de forme complémentaire réalisées dans le deuxième contact. Un exemple typique de structure interdigitée pour les deux contacts ressemble à deux peignes emboités l'un dans l'autre. D'autres structures présentant une complémentarité de forme entre les premier et deuxième contacts, maintenant un écart sensiblement constant entre les premier et deuxième contacts le long de leurs portions en regard l'une de l'autre, sont envisageables.
L'utilisation d'une structure interdigitée présente l'avantage de répartir le deuxième contact électrique sur une grande surface autour de l'absorbeur, tout en restreignant l'étendue du deuxième contact électrique sur le substrat. En effet, le deuxième contact électrique peut épouser la forme de l'absorbeur sur une partie au moins de la portion périphérique de l'absorbeur, permettant ainsi à une plus forte densité de courant de transiter depuis l'absorbeur vers le deuxième contact électrique en traversant l'espace séparant l'absorbeur du deuxième contact électrique. La structure interdigitée contribue ainsi à réduire les pertes résistives.

Selon un mode de réalisation, le deuxième contact électrique peut comprendre chacune des couches du premier contact électrique.
Un dispositif photovoltaïque dont le deuxième contact électrique comprend chacune des couches du premier contact électrique peut être réalisé par un simple procédé de gravure. Le deuxième contact électrique peut être structuré par gravure dans une couche du matériau constitutif du premier contact électrique recouvrant le substrat, afin de faire apparaître les premier et deuxième contacts électriques. Le deuxième contact électrique peut ensuite être traité et comprendre des couches supplémentaires par rapport au premier contact électrique.

Selon un mode de réalisation, l'absorbeur peut recouvrir des faces latérales et une face supérieure du premier contact électrique.

Un absorbeur encapsulant les parties exposées du premier contact électrique contribue à éviter tout courant de fuite entre les premier et deuxième contacts électriques via la couche transparente électriquement conductrice. En effet, lorsque l'absorbeur encapsule ainsi le premier contact électrique, le seul chemin viable pour un courant passant du premier contact électrique vers le deuxième contact électrique transite par l'absorbeur.

Avantageusement, le deuxième contact électrique peut comprendre en outre un matériau choisi parmi : l'acier 316L, un alliage Fe-Cr-Ni-Mo, Ni-Mo-P, MoO₂, ZnO, SnO₂, ZnO dopé aluminium, de l'oxyde d'étain dopé fluor FTO, des aciers contenant du carbone et du manganèse, des composés à base de cobalt et phosphore.

De tels matériaux, déposés sur le deuxième contact électrique, peuvent former une couche protégeant le deuxième contact électrique. Cette couche peut protéger le deuxième contact électrique de la corrosion dans un bain d'électrolyse lors du dépôt de l'absorbeur, ou bien des hautes températures intervenant lors de l'étape de recuit sous atmosphère sélénisante ou sulfurante pouvant intervenir lors de la fabrication de l'absorbeur. On entend par « haute température » des températures typiquement comprises entre 400°C et 650°C, et plus généralement les températures intervenant dans les recuits lors de la fabrication de cellules solaires en couches minces. En outre, la couche protège le deuxième contact électrique des vapeurs de sélénium, qui peuvent être nocives pour les métaux de ce deuxième contact électrique.

Selon un mode de réalisation, le dispositif photovoltaïque peut être à concentration de lumière.

Dans un dispositif photovoltaïque à concentration de lumière, l'agencement des deux contacts électrique selon l'invention est propice à une transmission efficace des fortes densités de courant intervenant dans l'absorbeur en limitant les pertes résistives depuis l'absorbeur vers les contacts électriques.

Selon l'invention, le dispositif photovoltaïque est agencé sous forme de panneau photovoltaïque semi-transparent. L'invention, de par l'agencement avantageux des deux contacts électriques sur le substrat, permet d'envisager une réduction de la surface du deuxième contact électrique. Ainsi, notamment lorsque le dispositif photovoltaïque est un panneau de cellules solaires à concentration de lumière, l'essentiel de la surface du substrat n'est recouverte ni par le premier contact électrique, ni par le deuxième contact électrique. Dans le cas d'un substrat transparent, cette particularité permet d'envisager une utilisation du dispositif photovoltaïque selon l'invention dans des vitres intégrant un panneau photovoltaïque à concentration de lumière.

L'invention se rapporte également à un procédé de fabrication d'un dispositif photovoltaïque en couches minces agencé sous forme de panneau photovoltaïque semi-transparent, comprenant :
- former au moins une première couche mince électriquement conductrice formant un premier contact électrique du dispositif photovoltaïque sur un substrat,
- former au moins une deuxième couche mince électriquement conductrice formant un deuxième contact électrique du dispositif photovoltaïque sur un substrat,
- déposer un absorbeur sur le premier contact électrique,
- déposer une couche transparente conductrice sur l'absorbeur,
le deuxième contact électrique étant espacé du premier contact électrique et la couche transparente conductrice étant en contact avec l'absorbeur et le deuxième contact électrique, et dans lequel le deuxième contact électrique et le premier contact électrique sont structurés de manière interdigitée. Ce procédé de fabrication présente l'avantage d'être simple, car il implique le dépôt des deux contacts électriques directement sur le substrat. Ce procédé peut en outre être réalisé à partir des techniques de fabrication de cellules solaires en couches minces, sans avoir recours à des machines d'alignement complexes pour placer les contacts électriques, qui sont directement formés sur le substrat, du même côté du substrat que l'absorbeur.
Selon un mode de réalisation, le procédé peut en outre comprendre :
- former la deuxième couche mince électriquement conductrice par gravure du premier contact électrique.
La réalisation des premier et deuxième contacts électriques par gravure offre un contrôle précis sur l'espace séparant ces deux contacts électriques, qui peut être choisi de sorte à ce que le deuxième contact électrique soit au plus près du premier contact électrique.
Une gravure permet en outre de contrôler la forme des premier et deuxième contacts électriques, de sorte à ce que le deuxième contact électrique soit agencé sur une portion plus ou moins grande de la périphérie du premier contact électrique.
Une gravure permet également d'obtenir des contacts électriques possédant des propriétés électriques équivalentes, le deuxième contact électrique possédant les mêmes couches et de sensiblement la même épaisseur que le premier contact électrique.

Selon l'invention, le procédé comprend :
- former les premier et deuxième contacts électriques de sorte que le deuxième contact électrique et le premier contact électrique soient structurés de manière interdigitée.
Selon un mode de réalisation, le procédé peut en outre comprendre :
- former les premier et deuxième contacts électriques de sorte que le deuxième contact électrique soit espacé du premier contact électrique d'une distance sensiblement égale à ou supérieure à une épaisseur de l'absorbeur.
Lorsque le deuxième contact électrique est espacé du premier contact électrique d'une distance sensiblement égale ou supérieure à l'épaisseur de l'absorbeur, l'absorbeur peut recouvrir le premier contact électrique de sorte à l'encapsuler. Une telle encapsulation réduit les courants de fuite du premier contact électrique vers le deuxième contact électrique.
Selon un mode de réalisation, déposer l'absorbeur sur le premier contact électrique peut en outre comprendre :
déposer un matériau précurseur de l'absorbeur sur le premier contact électrique par une technique choisie parmi : un électro-dépôt, .une évaporation, une impression d'encres, incorporer un matériau choisi parmi le sélénium et le soufre dans le matériau précurseur.

La formation de l'absorbeur par une technique d'électro-dépôt, l'impression d'encre ou certaines techniques d'évaporation présente l'avantage d'être effectuée de manière localisée, uniquement sur le premier contact électrique. À ce titre, l'électro-dépôt est une technique de dépôt sélectif particulièrement fiable puisqu'elle ne dépose le précurseur que sur une surface électriquement active, tel que le premier contact électrique par exemple.

Selon un mode de réalisation, le procédé peut en outre comprendre :
- former un matériau électriquement conducteur, résistant à la corrosion, stable en sélénisation ou sulfuration sur le deuxième contact électrique.

Un tel matériau permet de protéger le deuxième contact électrique de toute corrosion lors de l'électro-dépôt d'une couche du dispositif photovoltaïque, et de protéger ce deuxième contact électrique d'une étape de recuit, sous atmosphère sélénisante ou sulfurante.

Selon un mode de réalisation, le procédé peut en outre comprendre :
- former le matériau électriquement conducteur, résistant à la corrosion, stable en sélénisation ou sulfuration par une technique choisie parmi : un électro-dépôt, une oxydation thermique sous atmosphère oxydante d'une couche conductrice du deuxième contact électrique, une oxydation électrochimique d'une couche conductrice du deuxième contact électrique.

Selon un mode de réalisation, le procédé peut en outre comprendre :
- traiter le matériau électriquement conducteur, résistant à la corrosion, stable en sélénisation ou sulfuration en y ajoutant du phosphore.

L'ajout de phosphore permet de maintenir une structure amorphe dans les alliages de métaux utilisés pour protéger le deuxième contact électrique, tout en augmentant la résistance à la corrosion de ce dernier.

Selon un mode de réalisation, le procédé peut en outre comprendre :
- déposer une couche électriquement conductrice sur le deuxième contact électrique, postérieurement à une étape de recuit.

Ceci permet de réparer d'éventuels dégâts causés par l'étape de recuit sur les métaux du deuxième contact électrique.

### DESCRIPTIF DES FIGURES

Le procédé objet de l'invention sera mieux compris à la lecture de la description qui suit d'exemples de réalisations présentés à titre illustratif, aucunement limitatifs, et à l'observation des dessins ci-après sur lesquels :
- la figure 1 est une représentation schématique en vue de profil d'un dispositif photovoltaïque en couches minces selon un mode de réalisation;
- la figure 2 est une représentation schématique en vue de dessus d'un dispositif photovoltaïque en couches minces selon un mode de réalisation;
- la figure 3 est une représentation schématique de six étapes d'un procédé de fabrication d'un dispositif photovoltaïque selon un mode de réalisation.

Pour des raisons de clarté, les dimensions des différents éléments représentés sur ces figures ne sont pas nécessairement en proportion avec leurs dimensions réelles. Sur les figures, des références identiques correspondent à des éléments identiques.

### DESCRIPTION DÉTAILLÉE

La présente invention se rapporte à un dispositif photovoltaïque possédant des contacts électriques agencés d'une manière optimisée par rapport à l'absorbeur. Les contacts électriques décrits ci-après sont également plus faciles à construire et peuvent être positionnés avec précision par rapport à un absorbeur.

Notamment, l'invention se rapporte à des cellules solaires en couches minces pouvant être agencées en un panneau solaire équipé ou non d'un système à concentration de lumière.

L'invention propose un agencement original pour les deux contacts électriques situés à proximité de l'absorbeur permettant d'éviter d'obscurcir l'absorbeur et permettant une fabrication simple au plus près de l'absorbeur.

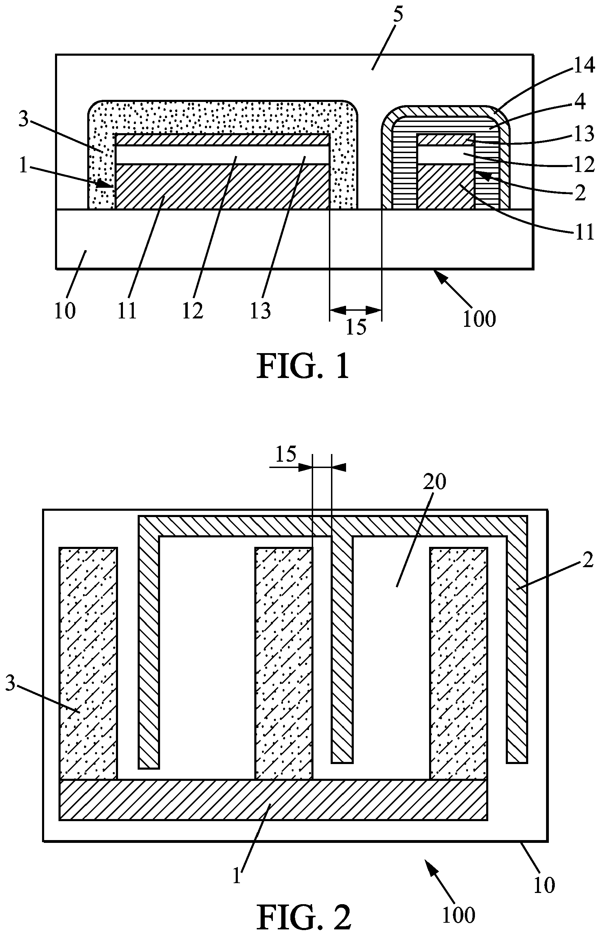

La figure 1 illustre schématiquement une vue en coupe d'un dispositif photovoltaïque 100 selon un mode de réalisation de l'invention. Ce dispositif photovoltaïque comprend un substrat 10, sur lequel repose un premier empilement de couches minces électriquement conductrices formant un premier contact électrique 1. Un deuxième empilement de couches minces électriquement conductrices formant un deuxième contact électrique 2 repose sur le même substrat 10.

Bien que la figure 1 illustre un empilement de couches minces, il est possible de n'utiliser qu'une seule couche pour former les premier et deuxième contacts électriques.

Comme représenté sur la figure 1, toute la surface inférieure des deux contacts électriques repose sur le substrat 10.

Sur la figure 1, les premier et deuxième contacts électriques sont réalisés à partir d'un même empilement de couches. Cet empilement se compose d'une couche conductrice 11, généralement en métal comme le molybdène d'une épaisseur comprise entre 500 nm et 1 µm. Alternativement, cette couche conductrice 11 peut être en un oxyde transparent conducteur comme par exemple du ZnO dopé aluminium, bore ou chlore, de l'oxyde d'étain dopé fluor FTO, de l'oxyde d'étain dopé indium ITO ou du SnO₂. Une couche barrière 12 d'une épaisseur typique de 50 nm en un alliage métallique tel que par exemple le MoN ou TiN sert à protéger la couche conductrice 11 d'un recuit sélénisant ou sulfurant. Une surcouche métallique 13 agencée sur la couche barrière 12 sert à favoriser un dépôt de l'absorbeur sur le premier contact électrique. Cette surcouche 13 est généralement en molybdène ou cuivre et possède une épaisseur typiquement comprise entre 50 nm et 300 nm. La surcouche de Mo est sacrificielle. Elle sert à former pendant le recuit une couche de MoSe₂ qui assure l'ohmicité du contact électrique.

Comme représenté sur la figure 1, les premier et deuxième contacts électriques sont tous deux agencés sur une même face du substrat 10, du même côté du substrat 10 que l'absorbeur 3 aux propriétés photovoltaïques. Compte tenu de cet agencement, le substrat 10 est électriquement isolant d'après la représentation de la figure 1 pour éviter un court-circuit entre les premier et deuxième contacts électriques. Toutefois, en guise d'alternative, il est possible de prévoir une couche isolante sur le substrat 10 et en-dessous des premier et deuxième contacts électriques.

Le deuxième contact électrique 2 est séparé du premier contact électrique 1 par un espace 15. Cet espace 15 permet de séparer électriquement le deuxième contact électrique 2 du premier contact électrique 1. Lors de la fabrication des premier et deuxième contacts électriques, la largeur de cet espace 15 peut être ajustée, tout comme la forme des premier et deuxième contacts électriques.

Le premier contact électrique 1 comprend, sur au moins sa surface supérieure, un absorbeur 3. L'absorbeur 3, tel que représenté sur la figure 1, recouvre également les faces latérales du premier contact électrique 1. Une telle encapsulation du premier contact électrique 1 par l'absorbeur 3 permet de réduire les courants de fuite du premier contact électrique 1 vers le deuxième contact électrique 2. Toutefois, il est possible que l'absorbeur 3 ne recouvre que partiellement ou pas du tout ces surfaces latérales. Les courants de fuite peuvent alors être réduits en prévoyant par exemple le dépôt d'une couche isolante dans l'espace 15 séparant le premier contact électrique 1 du deuxième contact électrique 2.

Le deuxième contact électrique 2 peut comprendre, sur au moins une partie de sa surface, un matériau 4 électriquement conducteur, résistant à la corrosion, stable en sélénisation ou sulfuration. Ce matériau permet de protéger ce deuxième contact électrique 2 de la corrosion provoquée par une étape ultérieure éventuelle d'électro-dépôt, ainsi que d'un recuit dommageable pour des couches métalliques. Un recuit sous atmosphère sélénisante et/ou sulfurante intervient typiquement lors de la fabrication de l'absorbeur 3 postérieurement au dépôt du deuxième contact électrique 2. De préférence, le matériau 4 électriquement conducteur, résistant à la corrosion, stable en sélénisation ou sulfuration possède en outre la propriété d'être facilement déposable sur une couche de molybdène ou de cuivre, et d'avoir une bonne résistance à l'ammoniaque, l'ammoniaque pouvant intervenir lors du dépôt des couches tampons recouvrant l'absorbeur 3.

Toutefois, il convient de remarquer que la présence du matériau 4 dans le deuxième contact électrique n'est pas nécessaire. Notamment, par exemple lorsque la couche 13 est de type MoN ou TiN, le deuxième contact électrique peut résister à un recuit sans subir de dégâts conséquents.

À titre d'exemple non limitatif, le matériau 4 électriquement conducteur, résistant à la corrosion, stable en sélénisation ou sulfuration peut être choisi parmi l'acier 316L, un alliage Fe-Cr-Ni-Mo, Ni-Mo-P, MoO₂, ZnO, SnO₂, ZnO dopé aluminium, de l'oxyde d'étain dopé fluor FTO, des aciers contenant du carbone et du manganèse, des composés à base de cobalt et phosphore. L'acier 316L est un matériau particulièrement adapté pour protéger le deuxième contact électrique 2. L'acier 316L se compose typiquement de 0,02% de carbone C, de 16% à 18% de chrome Cr, de 10,5% à 13% de nickel Ni, de 2% à 2,5% de molybdène Mo et de 2% de manganèse Mn. La présence de nickel et de chrome contribue typiquement à conférer une résistance à la corrosion dans un bain d'électro-dépôt. Le chrome réagit avec le dioxygène de l'air et forme une couche d'oxyde de chrome. Le nickel s'intègre à la couche d'oxyde et améliore les propriétés de la couche passive. La présence de métaux tels que le molybdène, le titane ou le cuivre permet d'améliorer encore la résistance chimique du deuxième contact électrique 2, en particulier dans les milieux non oxydants.

En outre, il est possible d'améliorer encore plus la résistance à la corrosion du matériau 4 électriquement conducteur, résistant à la corrosion, stable en sélénisation ou sulfuration par l'addition de phosphore P. Le phosphore promeut la formation d'une structure amorphe dans un alliage tel que l'acier 316L.

Le FTO possède la particularité de résister à la sélénisation ou sulfuration pendant près d'une heure à des températures de 600°C, et peut également convenir en guise de matériau 4. De même, le ZnO dopé aluminium ne réagit que partiellement avec le sélénium et le soufre à une température de 600°C et peut également convenir en guise de matériau 4.

Comme représenté sur la figure 1, le deuxième contact électrique 2 peut comprendre plus de couches que le premier contact électrique 1. Outre la présence possible d'un matériau 4 électriquement conducteur, résistant à la corrosion, stable en sélénisation ou sulfuration, le deuxième contact électrique peut comprendre, sur sa surface supérieure, une surcouche conductrice, en un matériau électriquement conducteur 14 typiquement en zinc.. D'autres métaux que le zinc peuvent également être envisagés. Cette surcouche conductrice permet d'ajuster les propriétés de conduction électrique du deuxième contact électrique 2.

Le contact électrique entre l'absorbeur 3 et le deuxième contact électrique 2 est assuré par la couche transparente 5 électriquement conductrice agencée sur l'absorbeur, en contact avec l'absorbeur et le deuxième contact électrique. Cette couche transparente 5 peut typiquement être la couche fenêtre en oxyde de zinc dopé aluminium du dispositif photovoltaïque 100. Alternativement, cette couche transparente 5 peut par exemple être en ZnO dopé chlore, dopé bore, le ZnMgO, l'oxyde d'étain dopé indium ITO ou FTO.

Cet agencement original des premier et deuxième contacts électriques dans le dispositif photovoltaïque 100 permet un rapprochement précis et maximal des premier et deuxième contacts électriques, pour évacuer de fortes densités de courant pouvant typiquement intervenir dans une cellule solaire à concentration de lumière.

Outre la minimisation de l'espace 15, l'efficacité avec laquelle le courant électrique généré dans l'absorbeur est collecté par le premier contact électrique 1 et le deuxième contact électrique 2 dépend de la forme de ces contacts électriques.

La figure 2 représente schématiquement en vue de dessus un exemple d'agencement entre le premier contact électrique 1 et le deuxième contact électrique 2. Le dispositif représenté se compose de contacts électriques sensiblement rectangulaires, agencés de sorte à former des peignes interdigités. La structure représentée sur la figure 2 est particulièrement adaptée pour évacuer de fortes densités de courant dans un dispositif photovoltaïque 100 à concentration de lumière. Le système de focalisation de la lumière sur l'absorbeur 3 n'est pas représenté sur la figure 2.

Compte tenu du fait que le premier contact électrique 1 est interdigité avec le deuxième contact électrique 2 , la portion du deuxième contact électrique 2 en regard du premier contact électrique 1 est grande, tout en conservant un espace 15 faible. Ceci permet d'évacuer efficacement de fortes densités de courant, tout en autorisant l'utilisation d'un deuxième contact électrique possédant des dimensions réduites. Ainsi, comme illustré sur la figure 2, l'essentiel de la surface supérieure du substrat 10 n'est recouverte ni par le premier contact électrique 1 ni par le deuxième contact électrique 2. Un espace libre 20 permet à la lumière incidente d'arriver directement sur le substrat et éventuellement de le traverser. Ainsi, il est possible de concevoir l'utilisation du dispositif photovoltaïque selon l'invention dans un vitrage, notamment lorsque le substrat 10 est translucide ou transparent.

La structure interdigitée représentée sur la figure 2 peut présenter de nombreuses variantes. Les formes des premier et deuxième contacts électriques peuvent varier, ainsi que l'espace 15 entre ces contacts. Il convient toutefois de préférer des structures dans lesquelles le premier contact comprend des parties saillantes agencées en regard de portions de forme complémentaires réalisées dans le deuxième contact, maintenant un écart sensiblement constant entre les premier et deuxième contacts le long de leurs portions en regard l'une de l'autre. Selon une variante avantageuse, les extrémités de la structure interdigitée des premier et deuxième contacts électriques peuvent être de forme trapézoïdale. La base des trapèzes des contacts, proche des bornes de la cellule, permet d'évacuer de plus grande quantités de courant.
En outre, la forme des contacts électriques peut être sélectionnée afin de conférer plus d'esthétisme à un panneau solaire, notamment lorsque le substrat est transparent et comprenant un système à concentration de la lumière.

Le dispositif photovoltaïque 100 selon l'invention présente également l'avantage de bénéficier d'un procédé de fabrication particulièrement simple et peu couteux à mettre à œuvre.

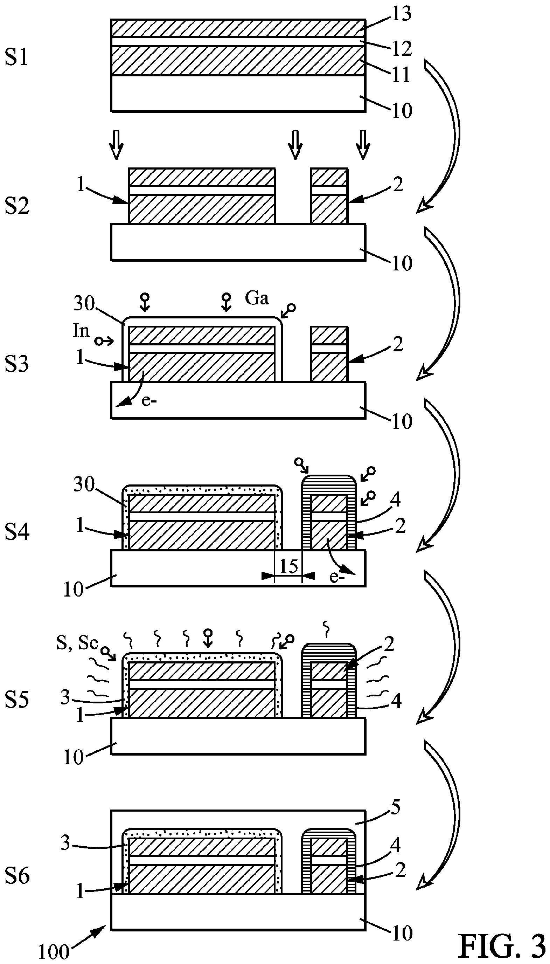

À titre d'exemple, la figure 3 propose 6 étapes de fabrication d'un dispositif photovoltaïque 100 selon l'invention.

Une première étape S1 peut comprendre le dépôt d'au moins une couche métallique sur un substrat 10. Dans l'exemple de la figure 3, le substrat est électriquement isolant et un empilement de trois couches telles que décrites ci-avant est déposé sur sa surface supérieure.

Lors d'une deuxième étape S2, l'empilement réalisé à l'étape S1 est gravé de sorte à faire apparaître dans l'empilement deux réseaux distincts formant le premier contact électrique 1 et le deuxième contact électrique 2, avant ajout de couches supplémentaires. Cette gravure peut être réalisée par ablation laser, électroérosion ou tout autre procédé de gravure connu, permettant de créer deux réseaux dont l'espacement est contrôlé et choisi.

En guise d'alternative à ces deux étapes, il est également possible d'envisager un dépôt direct de deux réseaux de couches métalliques distinctes pour former les deux contacts électriques sur le même substrat 10.

Ensuite, lors d'une étape S3, un précurseur 30 d'absorbeur est déposé sur le premier contact électrique 1. Ce dépôt peut être réalisé par électro-dépôt, procédé sélectif particulièrement avantageux qui utilise un courant appliqué au premier contact électrique pour ne déposer de l'indium et du gallium que sur ce contact électrique, sélectivement. D'autres procédés sélectifs, comme l'impression d'encres, peuvent être envisagés. Un procédé d'évaporation sélectif peut également être envisagé. Alternativement, des procédés non sélectifs, comme la pulvérisation cathodique ou la co-évaporation peuvent être mis en œuvre avec utilisation d'un masque.

En outre, un matériau électriquement conducteur 14 peut être déposé sur la surface supérieure du deuxième contact électrique 2, avantageusement après une étape de recuit sulfurant ou sélénisant. Ce matériau électriquement conducteur 14 peut par exemple être du zinc. Il peut être déposé sur au moins une partie de la surface supérieure du deuxième contact électrique 2 ou bien recouvrir la surface supérieure du deuxième contact électrique 2 et des faces latérales du deuxième contact électrique.

Lors d'une étape S4, le matériau 4 électriquement conducteur, résistant à la corrosion, stable en sélénisation ou sulfuration est formé sur le deuxième contact électrique 2. Ce dépôt peut se faire de différentes façons. Préférentiellement, il est effectué par électro-dépôt sélectif. Cette étape S4 de formation du matériau 4 est facultative.

Alternativement, il peut aussi être réalisé par oxydation thermique sous atmosphère oxydante, tel que l'air ou l'oxygène, en faisant passer un courant dans le deuxième contact électrique 2 de nature à chauffer ce dernier. L'oxydation thermique permet d'oxyde le molybdène du deuxième contact électrique de sorte à créer du MoO₂, en contrôlant différents paramètres de l'oxydation tels que le courant appliqué au deuxième contact électrique 2, la durée de l'oxydation et la concentration en agents oxydants.

Une autre variante de réalisation consiste à effectuer une oxydation électrochimique du molybdène du deuxième contact électrique 2 en contrôlant le potentiel électrique appliqué au deuxième contact électrique et le pH d'une solution électrolytique dans laquelle l'échantillon en cours de fabrication est plongé.

Il convient de remarquer que les étapes S3 et S4 décrites ci-avant peuvent être permutées.

Puis, le précurseur 30 subit un recuit thermique sous atmosphère riche en sélénium et/ou en soufre, lors d'une étape S5. Le deuxième contact électrique 2 est alors protégé par le matériau 4 formant une couche de protection autour des métaux susceptibles autrement d'être endommagés lors de cette étape de recuit.

Finalement, la fabrication du dispositif photovoltaïque 100 est complétée par le dépôt éventuel d'une couche tampon et d'une couche fenêtre. La couche transparente 5 électriquement conductrice assurant un contact électrique entre l'absorbeur 3 et le deuxième contact électrique 2 peut être la couche fenêtre du dispositif photovoltaïque, ou une autre couche. L'étape S6 représente schématiquement le dispositif photovoltaïque 100 ainsi obtenu.

Le dispositif photovoltaïque en couches minces décrit ci-avant et son procédé de fabrication offrent des contacts électriques positionnés avec précision, au plus près d'un absorbeur et sans obscurcir l'absorbeur. La fabrication de ce dispositif est en outre facilitée et moins coureuse que la fabrication de dispositifs de l'art antérieur. Le dispositif photovoltaïque décrit ci-avant est particulièrement adapté à des applications en tant que dispositif photovoltaïque à concentration de lumière.

## Revendications

1. Dispositif photovoltaïque (100) en couches minces agencé sous forme de panneau photovoltaïque semi-transparent, comprenant :
- un substrat (10),
- au moins une première couche mince électriquement conductrice formant un premier contact électrique (1) du dispositif photovoltaïque sur le substrat,
- un absorbeur (3) agencé sur le premier contact électrique,
- au moins une deuxième couche mince électriquement conductrice formant un deuxième contact électrique (2) du dispositif photovoltaïque sur le substrat,
- une couche transparente conductrice (5) agencée sur l'absorbeur,
le deuxième contact électrique étant espacé du premier contact électrique et la couche transparente conductrice étant en contact avec l'absorbeur et le deuxième contact électrique, et dans lequel le deuxième contact électrique (2) et le premier contact électrique (1) sont structurés de manière interdigitée.

2. Dispositif selon la revendication 1 dans lequel le deuxième contact électrique (2) comprend chacune des couches du premier contact électrique (1).

3. Dispositif selon l'une quelconque des revendications précédentes, dans lequel l'absorbeur (3) recouvre des faces latérales et une face supérieure du premier contact électrique (1).

4. Dispositif selon l'une quelconque des revendications précédentes, dans lequel le deuxième contact électrique (2) comprend en outre un matériau choisi parmi : l'acier 316L, un alliage Fe-Cr-Ni-Mo, Ni-Mo-P, MoO₂, ZnO, SnO₂, ZnO dopé aluminium, de l'oxyde d'étain dopé fluor FTO, des aciers contenant du carbone et du manganèse, des composés à base de cobalt et phosphore.

5. Dispositif selon l'une quelconque des revendications précédentes, dans lequel le dispositif photovoltaïque (100) est à concentration de lumière.

6. Procédé de fabrication d'un dispositif photovoltaïque (100) en couches minces agencé sous forme de panneau photovoltaïque semi-transparent, comprenant :
- former au moins une première couche mince électriquement conductrice formant un premier contact électrique (1) du dispositif photovoltaïque sur un substrat (10),
- former au moins une deuxième couche mince électriquement conductrice formant un deuxième contact électrique (2) du dispositif photovoltaïque sur le substrat,
- déposer un absorbeur (3) sur le premier contact électrique,
- déposer une couche transparente conductrice (5) sur l'absorbeur,
le deuxième contact électrique étant espacé du premier contact électrique et la couche transparente conductrice étant en contact avec l'absorbeur et le deuxième contact électrique et dans lequel le deuxième contact électrique (2) et le premier contact électrique (1) sont structurés de manière interdigitée.

7. Procédé selon la revendication 6, comprenant en outre :
- former la deuxième couche mince électriquement conductrice par gravure du premier contact électrique (1).

8. Procédé selon l'une quelconque des revendications 6 à 7, comprenant en outre :
- former les premier et deuxième contacts électriques de sorte que le deuxième contact électrique (2) soit espacé du premier contact électrique (1) d'une distance sensiblement égale à ou supérieure à une épaisseur de l'absorbeur (3).

9. Procédé selon l'une quelconque des revendications 6 à 8, dans lequel :
- déposer l'absorbeur (3) sur le premier contact électrique (1) comprend en outre :
déposer un matériau précurseur (30) de l'absorbeur sur le premier contact électrique par une technique choisie parmi : un électro-dépôt, .une évaporation, une impression d'encres,
incorporer un matériau choisi parmi le sélénium et le soufre dans le matériau précurseur.

10. Procédé selon l'une quelconque des revendications 6 à 9, comprenant en outre :
- former un matériau (4) électriquement conducteur, résistant à la corrosion, stable en sélénisation ou sulfuration sur le deuxième contact électrique (2).

11. Procédé selon la revendication 10, comprenant en outre :
- former le matériau (4) électriquement conducteur, résistant à la corrosion, stable en sélénisation ou sulfuration par une technique choisie parmi : un électro-dépôt, une oxydation thermique sous atmosphère oxydante d'une couche conductrice du deuxième contact électrique, une oxydation électrochimique d'une couche conductrice du deuxième contact électrique.

12. Procédé selon l'une quelconque des revendications 10 à 11, comprenant en outre :
- traiter le matériau (4) électriquement conducteur, résistant à la corrosion, stable en sélénisation ou sulfuration en y ajoutant du phosphore.

13. Procédé selon l'une quelconque des revendications 6 à 12, comprenant en outre :
- déposer une couche électriquement conductrice (14) sur le deuxième contact électrique, postérieurement à une étape de recuit.

## Patentansprüche

1. Dünnschicht-Photovoltaikvorrichtung (100), die in Form eines halbtransparenten Photovoltaikmoduls angeordnet ist, umfassend:
- ein Substrat (10),
- mindestens eine erste elektrisch leitfähige dünne Schicht, die einen ersten elektrischen Kontakt (1) der Photovoltaikvorrichtung auf dem Substrat bildet,
- einen Absorber (3), der auf dem ersten elektrischen Kontakt angeordnet ist,
- mindestens eine zweite elektrisch leitfähige dünne Schicht, die einen zweiten elektrischen Kontakt (2) der Photovoltaikvorrichtung auf dem Substrat bildet,
- eine auf dem Absorber angeordnete transparente leitfähige Schicht (5), wobei der zweite elektrische Kontakt vom ersten elektrischen Kontakt beabstandet ist und die transparente leitfähige Schicht mit dem Absorber und dem zweiten elektrischen Kontakt in Kontakt ist und wobei der zweite elektrische Kontakt (2) und der erste elektrische Kontakt (1) ineinandergreifend strukturiert sind.

2. Vorrichtung nach Anspruch 1, bei welcher der zweite elektrische Kontakt (2) jede der Schichten des ersten elektrischen Kontakts (1) umfasst.

3. Vorrichtung nach einem der vorhergehenden Ansprüche, bei welcher der Absorber (3) Seitenflächen und eine Oberseite des ersten elektrischen Kontakts (1) bedeckt.

4. Vorrichtung nach einem der vorhergehenden Ansprüche, bei welcher der zweite elektrische Kontakt (2) ferner ein Material umfasst, das ausgewählt ist aus: dem Stahl 316L, einer Legierung von Fe-Cr-Ni-Mo, Ni-Mo-P, MoO₂, ZnO, SnO₂, aluminiumdotiertem ZnO, fluordotiertem Zinnoxid FTO, Kohlenstoff und Mangan enthaltenden Stählen, Verbindungen auf der Basis von Kobalt und Phosphor.

5. Vorrichtung nach einem der vorhergehenden Ansprüche, bei welcher die Photovoltaikvorrichtung (100) lichtkonzentrierend ist.

6. Verfahren zur Herstellung einer Dünnschicht-Photovoltaikvorrichtung (100), die in Form eines halbtransparenten Photovoltaikmoduls angeordnet ist, umfassend:
- das Bilden mindestens einer ersten elektrisch leitfähigen dünnen Schicht, die einen ersten elektrischen Kontakt (1) der Photovoltaikvorrichtung auf einem Substrat (10) bildet,
- das Bilden mindestens einer zweiten elektrisch leitfähigen dünnen Schicht, die einen zweiten elektrischen Kontakt (2) der Photovoltaikvorrichtung auf dem Substrat bildet,
- das Abscheiden eines Absorbers (3) auf dem ersten elektrischen Kontakt,
- das Abscheiden einer transparenten leitfähigen Schicht (5) auf dem Absorber, wobei der zweite elektrische Kontakt vom ersten elektrischen Kontakt beabstandet ist und wobei die transparente leitfähige Schicht mit dem Absorber und dem zweiten elektrischen Kontakt in Kontakt ist und wobei der zweite elektrische Kontakt (2) und der erste elektrische Kontakt (1) ineinandergreifend strukturiert sind.

7. Verfahren nach Anspruch 6, umfassend ferner:
- das Bilden der zweiten elektrisch leitfähigen dünnen Schicht durch Ätzen des ersten elektrischen Kontakts (1).

8. Verfahren nach einem der Ansprüche 6 bis 7, umfassend ferner:
- das Bilden der ersten und zweiten elektrischen Kontakte derart, dass der zweite elektrische Kontakt (2) vom ersten elektrischen Kontakt (1) um einen Abstand von im Wesentlichen einer Dicke des Absorbers (3) oder mehr beabstandet ist.

9. Verfahren nach einem der Ansprüche 6 bis 8, bei dem:
- das Abscheiden des Absorbers (3) auf dem ersten elektrischen Kontakt (1) ferner umfasst:
das Abscheiden eines Vorläufermaterials (30) des Absorbers auf dem ersten elektrischen Kontakt mit einer Technik, die ausgewählt ist aus: elektrolytischer Abscheidung, Verdunsten, Tintendruck, dem Einarbeiten eines Materials, das unter Selen und Schwefel gewählt ist, in das Vorläufermaterial.

10. Verfahren nach einem der Ansprüche 6 bis 9, umfassend ferner:
- das Bilden eines elektrisch leitfähigen, korrosionsbeständigen, gegen Selenisierung oder Sulfidierung resitenten Materials (4) auf dem zweiten elektrischen Kontakt (2).

11. Verfahren nach Anspruch 10, umfassend ferner:
- das Bilden des elektrisch leitfähigen, korrosionsbeständigen, gegen Selenisierung oder Sulfidierung resistenten Materials (4) mit einer Technik, die ausgewählt ist aus: elektrolytischer Abscheidung, thermischer Oxidation unter oxidierender Atmosphäre einer leitfähigen Schicht des zweiten elektrischen Kontakts, elektrochemischer Oxidation einer leitfähigen Schicht des zweiten elektrischen Kontakts.

12. Verfahren nach einem der Ansprüche 10 bis 11, umfassend ferner:
- das Behandeln des elektrisch leitfähigen, korrosionsbeständigen, gegen Selenisierung oder Sulfidierung resistenten Materials (4) durch Zugeben von Phosphor.

13. Verfahren nach einem der Ansprüche 6 bis 12, umfassend ferner:
- das Abscheiden einer elektrisch leitfähigen Schicht (14) auf dem zweiten elektrischen Kontakt nach einem Schritt des Glühens.

## Claims

1. A thin-film photovoltaic device (100) in the form of a semi-transparent photovoltaic panel, comprising:
- a substrate (10),
- at least a first electrically conductive thin layer forming a first electrical contact (1) of the photovoltaic device on the substrate,
- an absorber (3) arranged on the first electrical contact,
- at least a second electrically conductive thin layer forming a second electrical contact (2) of the photovoltaic device on the substrate,
- a transparent conductive layer (5) arranged on the absorber,
the second electrical contact being spaced apart from the first electrical contact, and the transparent conductive layer being in contact with the absorber and the second electrical contact, and wherein the second electrical contact (2) and the first electrical contact (1) are structured in an interleaved manner.

2. Device according to claim 1, wherein the second electrical contact (2) comprises each of the layers of the first electrical contact (1).

3. Device according to any one of the preceding claims, wherein the absorber (3) covers side faces and an upper face of the first electrical contact (1).

4. Device according to any one of the preceding claims, wherein the second electrical contact (2) further comprises a material selected among: 316L stainless steel, an alloy of Fe-Cr-Ni-Mo, Ni-Mo-P, MoO₂, ZnO, SnO₂, aluminum-doped ZnO, fluorine-doped tin oxide FTO, steels containing carbon and manganese, compounds based on cobalt and phosphorus.

5. Device according to any one of the preceding claims, wherein the photovoltaic device (100) is a light-concentrating device.

6. Method for fabricating a thin film photovoltaic device (100) in the form of a semi-transparent photovoltaic panel, comprising:
- forming at least a first electrically conductive thin layer forming a first electrical contact (1) of the photovoltaic device on a substrate (10),
- forming at least a second electrically conductive thin layer forming a second electrical contact (2) of the photovoltaic device on the substrate,
- depositing an absorber (3) on the first electrical contact,
- depositing a transparent conductive layer (5) on the absorber,
the second electrical contact being spaced apart from the first electrical contact, and the transparent conductive layer being in contact with the absorber and the second electrical contact, and wherein the second electrical contact (2) and the first electrical contact (1) are structured in an interleaved manner.

7. Method according to claim 7, further comprising:
- forming the second electrically conductive thin layer by etching the first electrical contact (1).

8. Method according to any one of claims 6 to 7, further comprising:
- forming the first and second electrical contacts such that the second electrical contact (2) is spaced apart from the first electrical contact (1) by a distance substantially equal to or greater than a thickness of the absorber (3).

9. Method according to any one of claims 6 to 8, wherein:
- depositing the absorber (3) on the first electrical contact (1) further comprises:
depositing a precursor material (30) of the absorber on the first electrical contact by a technique selected among: electrodeposition, evaporation, ink printing,
incorporating a material selected among selenium and sulfur into the precursor material.

10. Method according to any one of claims 6 to 9, further comprising:
- forming a corrosion-resistant, electrically conductive material (4) that is stable in selenization or sulfurization, on the second electrical contact (2).

11. Method according to claim 10, further comprising:
- forming the corrosion-resistant, electrically conductive material that is stable in selenization or sulfurization, by a technique selected among: electrodeposition, thermal oxidation in an oxidizing atmosphere of a conductive layer of the second electrical contact, electrochemical oxidation of a conductive layer of the second electrical contact.

12. Method according to any one of claims 10 to 11, further comprising:
- treating the corrosion-resistant, electrically conductive material (4) that is stable in selenization or sulfurization, by adding phosphorus.

13. Method according to any one of claims 6 to 12, further comprising:
- depositing an electrically conductive layer (14) on the second electrical contact, subsequent to an annealing step.
